# EUROPEAN PATENT APPLICATION

(11) **EP 2 182 635 A2**
(43) Date of publication of application: **05.05.2010**
(21) Application number: 09168640.2
(22) Date of filing: 25.08.2009
(51) Int. Cl.: H03K 17/08

(54) **Single fault tolerant isolated dual bus power input circuits and systems**

(30) Priority: 31.10.2008 US 263370
(71) Applicant: Honeywell International Inc., Morristown, NJ 07962-2245 (US)
(72) Inventor: Santrach, Paul, Morristown, NJ 07962-2245 (US); Cebry, George, Morristown, NJ 07962-2245 (US)
(74) Representative: Buckley, Guy Julian

(57) **Abstract**

Single fault tolerant isolated dual bus power input circuits and systems are provided. One input circuit comprises a first bus and a second bus configured to be coupled to first and second power sources, respectively. The first bus includes first input and return lines, the first input or return line including a switch. The second bus includes second input and return lines, the second input or return line including two switches coupled in series. A system includes multiple power sources coupled to an electronic device via the input circuit discussed above. Another system includes multiple power sources, an electronic device, and an input circuit coupling the electronic device to the power sources. The input circuit includes multiple input lines coupling the electronic device to a respective power source, wherein each input line includes a switch coupled between the electronic device and each respective power source.

## Description

### STATEMENT REGARDING FEDERALLY SPONSORED RESEARCH OR DEVELOPMENT

The United States Government has a paid-up license in this invention and the right in limited circumstances to require the patent owner to license others on reasonable terms as provided by the terms of Contract No. NNJ06TA25C and Sub-Contract No. RH6-118204 awarded by NASA.

### FIELD OF THE INVENTION

The present invention generally relates to power input circuits, and more particularly relates to isolated dual bus power input circuits that are single fault tolerant.

### BACKGROUND OF THE INVENTION

In aerospace applications, efficiency and reliability are important factors in designing electronic systems. That is, an ideal electronic system includes features that enable the electronic system to be light weight and consume a minimal amount of power, while also providing features that enable the electronic system to operate in the unlikely event of a partial system malfunction.

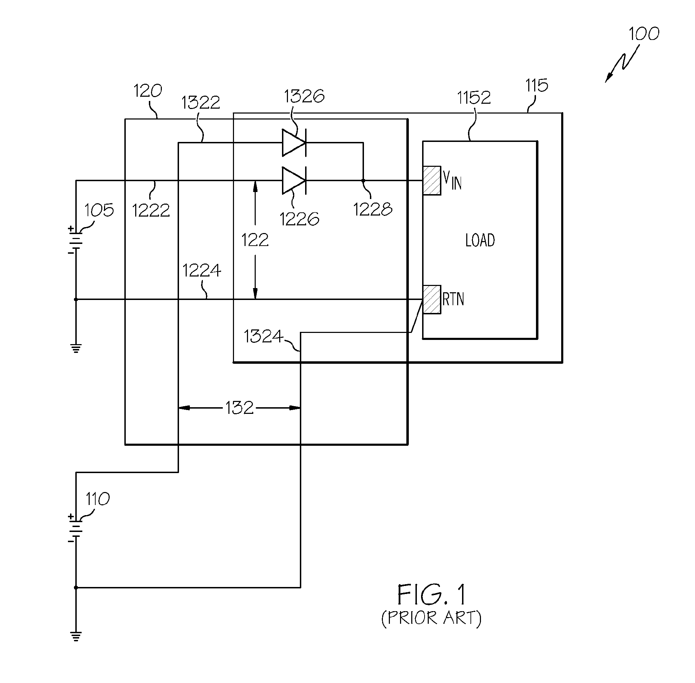

FIG. 1 is a schematic diagram of a prior art electronic system 100 having a plurality of power sources 105, 110 connected to an electronic device 115 via an input circuit 120 having a high side isolation, dual bus configuration.

In aerospace applications, power sources 105, 110 are typically 28 volt power supplies. In other applications, power sources 105, 110 may provide a greater or smaller amount of voltage.

Electronics device 115 may be, for example, a line-replaceable unit (LRU) including a load 1152. Examples of an LRU include, but are not limited to, a radio, a global positioning system (GPS), a radar system, and the like auxiliary devices. As discussed above, electronic device 115 is connected to power sources 105, 110 via input circuit 120.

Input circuit 120 includes a primary bus 122 having an input line 1222 and a return line 1224 connecting power source 105 to load 1152. Input line 1222 includes a diode 1226 having an anode connected to the positive terminal of power supply 105 and a cathode connected to a node 1228, which is connected to the input (Vᵢₙ) terminal of load 1152. Return line 1224 connects the negative terminal of power source 105 to the return (RTN) terminal of load 1152.

Input circuit 120 further includes a secondary (or redundant) bus 132 having an input line 1322 and a return line 1324 connecting power source 110 to load 1152. Input line 1322 includes a diode 1326 connected to the positive terminal of power supply 110 and a cathode connected to node 1228. Return line 1324 connects the negative terminal of power source 110 to the RTN terminal of load 1152.

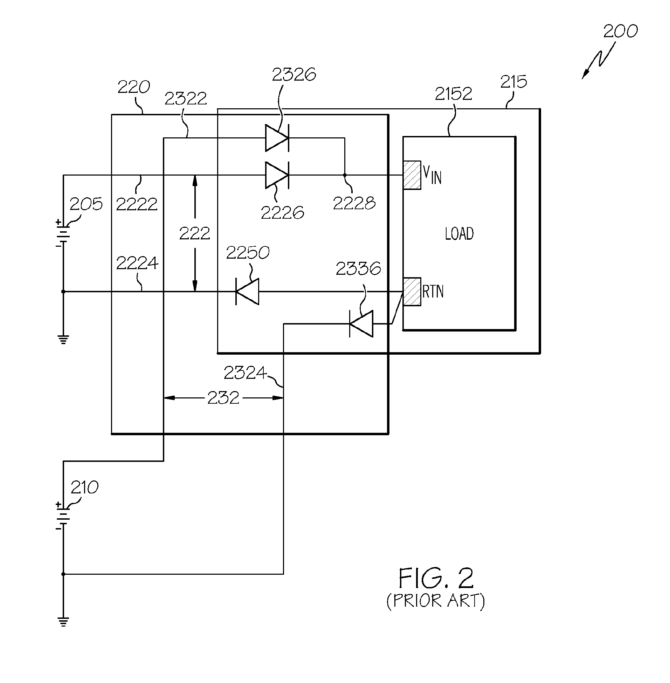

FIG. 2 is a schematic diagram of a prior art electronic system 200 having a plurality of power sources 205, 210 connected to an electronic device 215 via an input circuit 220 having a high/low side isolation, dual bus configuration. In the design illustrated in FIG. 2, power sources 205, 210 and electronic device 215 (including load 2152) are similar to power sources 105, 110 and electronic device 115 (and load 1152), respectively, discussed above with reference to FIG. 1. The difference between system 100 and system 200 is that input circuit 120 has a high side isolation, dual bus configuration while input circuit 220 has a high/low side isolation, dual bus configuration.

Input circuit 220 includes a primary bus 222 having an input line 2222 and a return line 2224 connecting power source 205 to load 2152. Input line 2222 includes a diode 2226 having an anode connected to the positive terminal of power supply 205 and a cathode connected to a node 2228, which is connected to the Vᵢₙ terminal of load 2152.

Similar to return line 1224 in FIG. 1, return line 2224 connects the negative terminal of power source 205 to the RTN terminal of load 2152. However, in contrast to return line 1224, return line 2224 includes a diode 2250 having an anode connected to the RTN terminal of load 2152 and a cathode connected to the negative terminal of power source 205.

Input circuit 220 further includes a secondary (or redundant) bus 232 having an input line 2322 and a return line 2324 connecting power source 210 to load 2152. Input line 2322 includes a diode 2326 having an anode connected to the positive terminal of power supply 210 and a cathode connected to node 2228.

Similar to return line 1324 in FIG. 1, return line 2324 connects the negative terminal of power source 210 to the RTN terminal of load 2152. However, in contrast to return line 1324, return line 2324 includes a diode 2336 having a cathode connected to the negative terminal of power supply 210 and an anode connected to the RTN terminal of load 2152.

While input circuits 120 and 220 are each fully capable of performing the functionality of their respective designs, input circuits 120 and 220 are heavier than they should be and consume more power than they should consume. Accordingly, it is desirable to provide single fault tolerant isolated dual bus power input circuits that consume less power than previous input circuits. Furthermore, other desirable features and characteristics of the present invention will become apparent from the subsequent detailed description of the invention and the appended claims, taken in conjunction with the accompanying drawings and this background of the invention.

### BRIEF SUMMARY OF THE INVENTION

Various embodiments provide input circuits for an electronic device configured to be coupled to a plurality of power sources. One input circuit comprises a first bus configured to be coupled to a first power source. The first bus includes a first input line and a first return line, and the first input line or the first return line comprises a first switch. The input circuit further comprises a second bus configured to be coupled to a second power source. The second bus includes a second input line and a second return line, and the second input line or the second return line comprises a second switch and a third switch coupled in series.

Various embodiments also provide electronic systems. One system comprises a first power source including a first positive terminal and a first negative terminal, a second power source including a second positive terminal and a second negative terminal, an electronic device including an input terminal and a return terminal, and an input circuit coupling the electronic device to the first power source and the second power source. The input circuit comprises a first bus comprising a first input line coupling the input terminal and the first positive terminal, a first switch coupled between the input terminal and the first positive terminal, and a first return line coupling the return terminal and the first negative terminal. The input circuit further comprises a second bus comprising a second input line coupling the input terminal and the second positive terminal, a second switch and a third switch coupled in series between the input terminal and the second positive terminal, and a second return line coupling the return terminal and the second negative terminal.

Another system comprises a plurality of power sources, an electronic device, and an input circuit coupling the electronic device to the plurality of power sources. The input circuit comprises a plurality of input lines, each input line coupling the electronic device to a respective power source and comprising a switch coupled between the electronic device and the respective power source.

### BRIEF DESCRIPTION OF THE DRAWINGS

The present invention will hereinafter be described in conjunction with the following drawing figures, wherein like numerals denote like elements, and

FIG. 1 is a schematic diagram of a prior art electronic system having a plurality of power sources connected to an electronic device via a high side isolation, dual bus power input circuit;

FIG. 2 is a schematic diagram of a prior art electronic system having a plurality of power sources connected to an electronic device via a high/low side isolation, dual bus power input circuit;

FIG. 3 is a schematic diagram an electronic system comprising a plurality of power sources coupled to an electronic device via a high side isolation, dual bus power input circuit in accordance with one embodiment of the present invention;

FIG. 4 is a schematic diagram an electronic system comprising a plurality of power sources coupled to an electronic device via a high/low side isolation, dual bus power input circuit in accordance with another embodiment of the present invention;

FIGS. 5A-5G are schematic diagrams illustrating the operation of the electronic systems of FIG. 4;

FIG. 6 is a schematic diagram a specific embodiment of the electronic system of FIG. 3; and

FIG. 7 is a schematic diagram a specific embodiment of the electronic system of FIG. 4.

### DETAILED DESCRIPTION OF THE INVENTION

The following detailed description of the invention is merely exemplary in nature and is not intended to limit the invention or the application and uses of the invention. Furthermore, there is no intention to be bound by any theory presented in the preceding background of the invention or the following detailed description of the invention.

Various embodiments of the present invention provide an electronic system comprising an improved high side isolation, dual bus power input circuit. Various other embodiments provide an electronic system comprising an improved high/low side isolation, dual bus power input circuit.

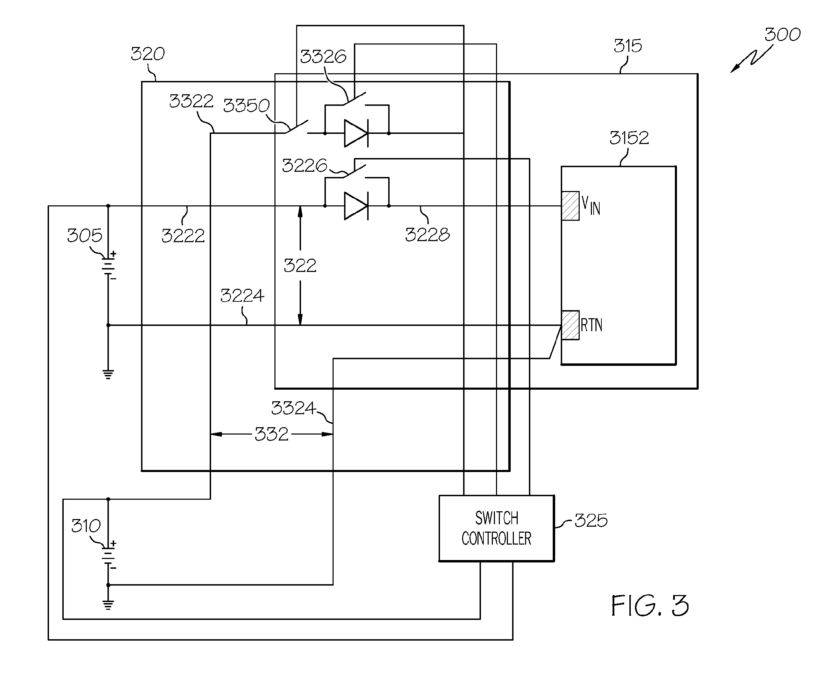

Turning now to the figures, FIG. 3 is a schematic diagram of an electronic system 300 including a plurality of power sources 305, 310 coupled to an electronic device 315 via an input circuit 320 including a high side isolation, dual bus configuration. System 300 also includes a switch controller 325 coupled to input circuit 320 and configured to control the ON/OFF state of one or more switches (discussed below) included in input circuit 320.

In the embodiment illustrated in FIG. 3, power sources 305, 310 and electronic device 315 (including load 3152) are similar to power sources 105, 110 and electronic device 115 (and load 1152), respectively, discussed above with reference to FIG. 1. Among other elements, one difference between system 100 and system 300 is that input circuit 120 uses diodes 1226 and 1326 for high side isolation and input circuit 320 uses switches 3226, 3326, and 3350 for high side isolation.

Input circuit 320 includes a primary bus 322 including a return line 3224 and an input line 3222 coupling power source 305 to load 3152. Specifically, return line 3224 couples the negative terminal of power source 305 to the RTN terminal of load 3152 and input line 3222 couples the positive terminal of power source 305 to the Vᵢₙ terminal of load 3152.

Input line 3222 includes switch 3226 coupled to the positive terminal of power supply 305 and to a node 3228, which is connected to the Vᵢₙ terminal of load 3152.

Switch 3226 may be any type of semiconductor switch known in the art or developed in the future. In one embodiment, switch 3226 is an N-channel metal oxide semiconductor field-effect transistor (MOSFET). In another embodiment, switch 3226 is a P-channel MOSFET. In yet another embodiment, switch 3226 is an insulated gate bipolar junction transistor (IGBT). In still another embodiment, switch 3226 is a bipolar junction transistor.

Input circuit 320 further includes a secondary (or redundant) bus 332 comprising a return line 3324 and an input line 3322 coupling power source 310 to load 3152. Specifically, return line 3324 couples the negative terminal of power source 310 to the RTN terminal of load 3152 and input line 3322 couples the positive terminal of power source 310 to the Vᵢₙ terminal of load 3152.

Input line 3322 includes switch 3326 coupled in series with switch 3350, which coupled to the positive terminal of power supply 310. Switches 3326 and 3350 may be any type of semiconductor switch known in the art or developed in the future. In one embodiment, switches 3326 and 3350 are N-channel MOSFETs. In another embodiment, switch 3326 and 3350 are P-channel MOSFETs. In yet another embodiment, switches 3326 and 3350 are IGBTs. In still another embodiment, switches 3326 and 3350 are bipolar junction transistors.

Switch controller 325 may be any system, device, hardware (and software), and combinations thereof capable of controlling the ON/OFF state of switches 3226, 3326, and 3350. That is, switch controller 325 is configured to switch ON/OFF switches 3226, 3326, and 3350 in accordance with the operation of system 300.

During operation, when system 300 is working properly switch 3226 is ON and switches 3326 and 3350 are both OFF such that power source 305 provides power to electronic device 315. In the unlikely event that power source 305 and/or primary bus 322 malfunctions, switches 3326 and 3350 both turn ON, and switch 3226 turns OFF such that power source 310 provides power to electronic device 315. In this manner, system 300 ensures that power is supplied to electronic device 315 and that the high side of input circuit 320 is isolated. Furthermore, because input circuit 320 uses switches 3226 and 3326 for high side isolation, input circuit 320 consumes less power and is lighter in weight because lower power dissipation means a smaller heat sink needed than previous input circuits.

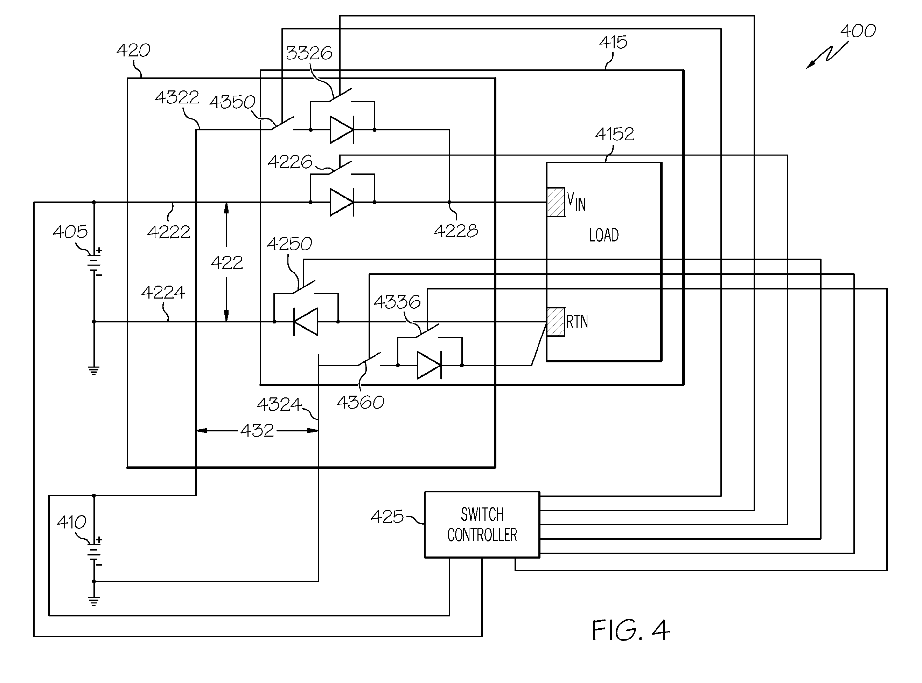

FIG. 4 is a schematic diagram of an electronic system 400 having a plurality of power sources 405, 410 coupled to an electronic device 415 via an input circuit 420 including a high/low side isolation, dual bus configuration. System 400 also includes a switch controller 425 coupled to input circuit 420 and configured to control the ON/OFF state of one or more switches (discussed below) included in input circuit 420.

In the embodiment illustrated in FIG. 4, power sources 405, 410 and electronic device 415 (including load 4152) are similar to power sources 205, 210 and electronic device 215 (and load 2152), respectively, discussed above with reference to FIG. 2. Among other elements, one difference between system 200 and system 400 is that input circuit 220 uses diodes 2226, 2250, 2326, and 2336 for high/low side isolation and input circuit 420 uses switches 4226, 4250, 4326, 4336, 4350, and 4360 for high/low side isolation.

Input circuit 420 includes a primary bus 422 including a return line 4224 and an input line 4222 coupling power source 405 to load 4152. Return line 4224 connects the negative terminal of power source 405 to the RTN terminal of load 4152 and includes a switch 4250.

Switch 4250 may be any type of semiconductor switch known in the art or developed in the future. In one embodiment, switch 4250 is an N-channel MOSFET. In another embodiment, switch 4250 is a P-channel MOSFET. In yet another embodiment, switch 4250 is an IGBT. In still another embodiment, switch 4250 is a bipolar junction transistor.

Input line 4222 includes switch 4226 coupled to the positive terminal of power supply 405 and to a node 4228, which is connected to the Vᵢₙ terminal of load 4152. Switch 4226 may be any type of semiconductor switch known in the art or developed in the future. In one embodiment, switch 4226 is an N-channel MOSFET. In another embodiment, switch 4226 is a P-channel MOSFET. In yet another embodiment, switch 4226 is a PNP IGBT. In still another embodiment, switch 4226 is an NPN IGBT

Input circuit 420 further includes a secondary (or redundant) bus 432 comprising a return line 4324 and an input line 4322 coupling power source 410 to load 4152. That is, return line 4324 connects the negative terminal of power source 410 to the RTN terminal of load 4152. Specifically, return line 4324 comprises a switch 4336 coupled to the RTN terminal of load 4152. Switch 4336 is further coupled in series with a switch 4360 that is coupled to the negative terminal of power supply 410.

Switches 4336 and 4360 may be any type of semiconductor switch known in the art or developed in the future. In one embodiment, switches 4336 and 4360 are N-channel MOSFETs. In another embodiment, switch 4336 and 4360 are P-channel MOSFETs. In yet another embodiment, switches 4336 and 4360 are IGBTs. In still another embodiment, switches 4336 and 4360 are bipolar junction transistors.

Input line 4322 connects the positive terminal of power source 410 to node 4228, which is coupled to the Vᵢₙ terminal of load 4152. Specifically, input line 4322 comprises switch 4326 coupled to node 4228. Switch 4326 is further coupled in series with switch 4350 that is coupled to the positive terminal of power supply 410.

Switches 4326 and 4350 may be any type of semiconductor switch known in the art or developed in the future. In one embodiment, switches 4326 and 4350 are N-channel MOSFETs. In another embodiment, switch 4326 and 4350 are P-channel MOSFETs. In yet another embodiment, switches 4326 and 4350 are IGBTs. In still another embodiment, switches 4326 and 4350 are bipolar junction transistors.

Switch controller 425 may be any system, device, hardware (and software), and combinations thereof capable of controlling the ON/OFF state of switches 4226, 4250, 4326, 4336, 4350, and 4360. That is, switch controller 425 is configured to switch ON/OFF switches 4226, 4250, 4326, 4336, 4350, and 4360 in accordance with the operation of system 400.

During operation, when system 400 is working properly switches 4226 and 4250 are both ON, and switches 4326, 4350, 4336, and 4360 are each OFF such that power source 405 provides power to electronic device 415. In the unlikely event that power source 405 and/or primary bus 422 malfunctions, switches 4326, 4350, 4336, and 4360 each turn ON, and switches 4226 and 4250 are both turned OFF such that power source 410 provides power to electronic device 415. In this manner, system 400 ensures that power is supplied to electronic device 415 and that the high side and low side of input circuit 420 are isolated. Furthermore, because input circuit 420 uses switches 4226, 4250, 4326, 4336, 4350, and 4360 for high/low side isolation, input circuit 420 consumes less power and is lighter in weight because lower power dissipation means a smaller heat sink needed than previous input circuits.

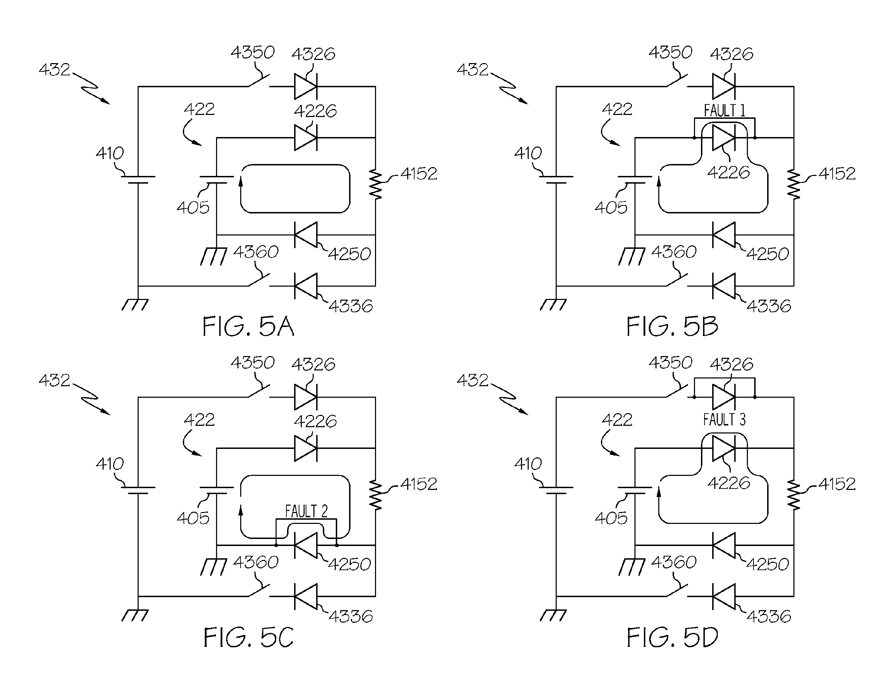

FIGS. 5A-5G are schematic diagrams illustrating the isolating operation of electronic system 400. That is, electronic system 400 ensures that power is no exchanged between primary bus 422 and secondary or redundant bus 432. Specifically, switches 4226, 4250, 4326, 4336, 4350, and 4360 are configured in a manner the prevents connection between primary bus 422 and secondary bus 432 if a fault occurs on any one device on primary bus 422 or secondary bus 432.

Notably, one skilled in the art will appreciate that the discussion above with reference to FIGS. 5A-5G are also applicable to electronic system 300, and electronic systems 600 and 700, each of which is discussed below. Furthermore, for discussion purposes, only the diode portion of switches 4226, 4250, 4326, and 4336 are illustrated in FIGS. 5A-5G.

FIG. 5A illustrates the isolating operation of electronic system 400 when electronic system 400 is functioning properly. In FIG. 5A, switch 4350 and/or 4360 are switched OFF (i.e., open) such that there is no connection between primary bus 422 and secondary bus 432. That is, with switch 4350 and/or 4630 turned OFF, there is no power exchange between primary bus 422 and secondary bus 432.

FIG. 5B illustrates the situation in which there is a short (i.e., fault 1) or other type of malfunction in switch 4226. In this situation, secondary bus 432 cannot be driven by primary bus 422 because switch 4350 and/or switch 4360 being turned OFF breaks any connection (e.g., power exchange) between primary bus 422 and secondary bus 432.

FIG. 5C illustrates the situation in which there is a short (i.e., fault 2) or other type of malfunction in switch 4250. Similar to the situation illustrated in FIG. 5B, secondary bus 432 cannot be driven by primary bus 422 because switch 4350 and/or switch 4360 being turned OFF breaks any connection (e.g., power exchange) between primary bus 422 and secondary bus 432.

FIG. 5D illustrates the situation in which there is a short (i.e., fault 3) or other type of malfunction in switch 4326. Similar to the situation illustrated in FIGS. 5B and 5C, secondary bus 432 cannot be driven by primary bus 422 because switch 4350 and/or switch 4360 being turned OFF breaks any connection (e.g., power exchange) between primary bus 422 and secondary bus 432.

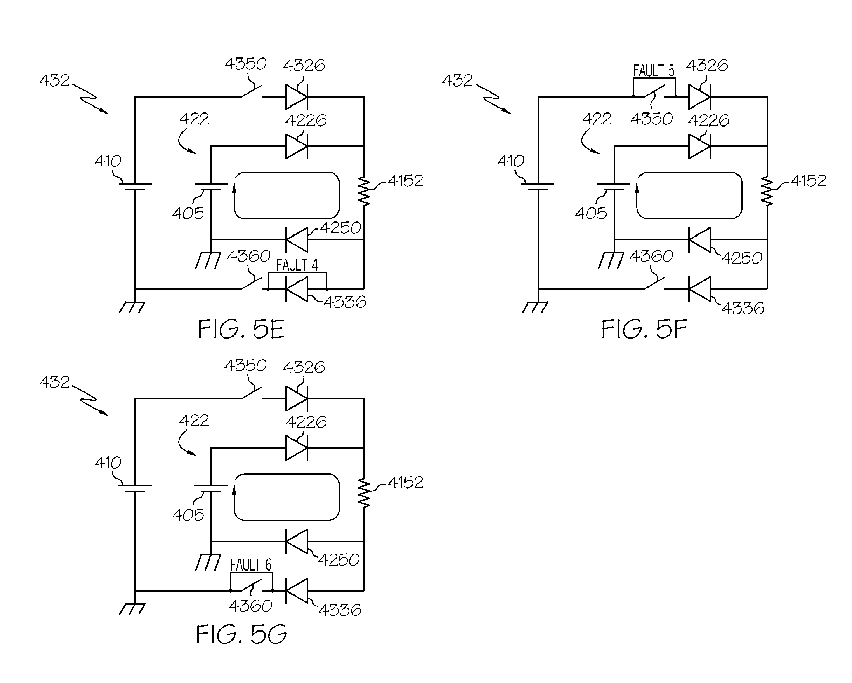

FIG. 5E illustrates the situation in which there is a short (i.e., fault 4) or other type of malfunction in switch 4336. Similar to the situation illustrated in FIGS. 5B-5D, secondary bus 432 cannot be driven by primary bus 422 because switch 4350 and/or switch 4360 being turned OFF breaks any connection (e.g., power exchange) between primary bus 422 and secondary bus 432.

FIG. 5F illustrates the situation in which there is a short (i.e., fault 5) or other type of malfunction in switch 4350. In this situation, secondary bus 432 cannot be driven by primary bus 422 because switch 4360 being turned OFF creates an open circuit that breaks any connection (e.g., power exchange) between primary bus 422 and secondary bus 432.

Similarly, FIG. 5G illustrates the situation in which there is a short (i.e., fault 6) or other type of malfunction in switch 4360. In this situation, secondary bus 432 cannot be driven by primary bus 422 because switch 4350 being turned OFF creates an open circuit that breaks any connection (e.g., power exchange) between primary bus 422 and secondary bus 432.

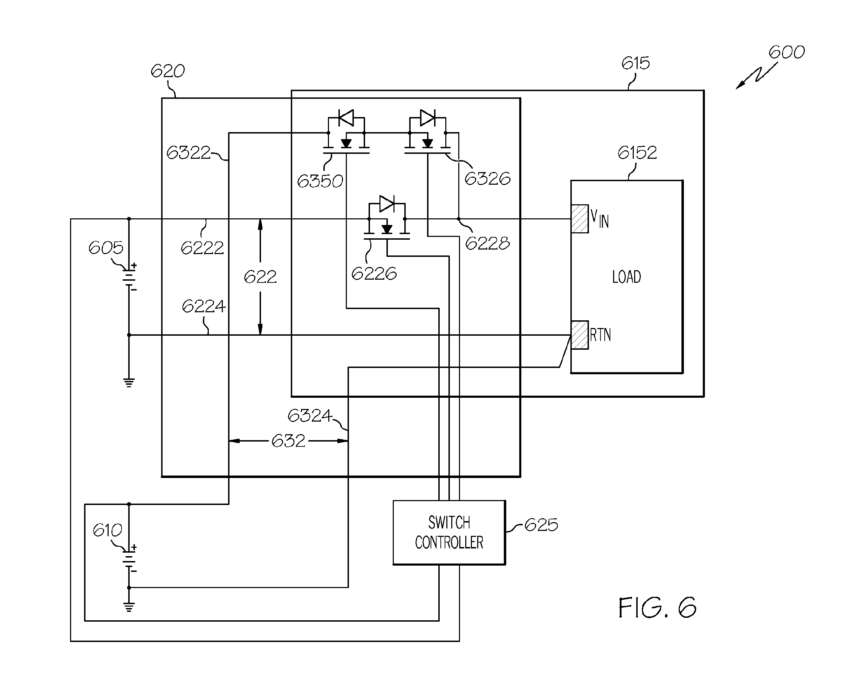

FIG. 6 is a schematic diagram of an electronic system 600 including a plurality of power sources 605, 610 coupled to an electronic device 615 via an input circuit 620 including a high side isolation, dual bus configuration. System 600 also includes a switch controller 625 coupled to input circuit 620 and configured to control the ON/OFF state of one or more switches (discussed below) included in input circuit 620.

In the embodiment illustrated in FIG. 6, power sources 605, 610 and electronic device 615 (including load 6152) are similar to power sources 105, 110 and electronic device 115 (and load 1152), respectively, discussed above with reference to FIG. 1. Among other elements, one difference between system 100 and system 600 is that input circuit 120 uses diodes 1226 and 1326 for high side isolation and input circuit 620 uses switches 6226 and 6326 for high side isolation.

Input circuit 620 includes a primary bus 622 including a return line 6224 and an input line 6222 coupling power source 605 to load 6152. Specifically, return line 6224 couples the negative terminal of power source 605 to the RTN terminal of load 6152 and input line 6222 couples the positive terminal of power source 605 to the Vᵢₙ terminal of load 6152.

Input line 6222 includes switch 6226 coupled to the positive terminal of power supply 605 and to a node 6228, which is connected to the Vᵢₙ terminal of load 6152. In the embodiment illustrated in FIG. 6, switch 6226 is an N-channel metal oxide semiconductor field-effect transistor (MOSFET) device including a source coupled to the positive terminal of power supply 605 and a drain coupled to node 6228.

Input circuit 620 further includes a secondary (or redundant) bus 632 comprising a return line 6324 and an input line 6322 coupling power source 610 to load 6152. Specifically, return line 6324 couples the negative terminal of power source 610 to the RTN terminal of load 6152 and input line 6322 couples the positive terminal of power source 610 to the Vᵢₙ terminal of load 6152.

Input line 6322 includes a switch 6326 coupled in series with a switch 6350 that is coupled to the positive terminal of power supply 610. In the embodiment illustrated in FIG. 6, switches 6326 and 6350 are both N-channel MOSFET devices with their sources serially coupled to one another. The drain of switch 6350 is coupled to the positive terminal of power supply 610 and the drain of switch 6326 is coupled to node 6228.

Switch controller 625 may be any system, device, hardware (and software), and combinations thereof capable of controlling the ON/OFF state of switches 6226, 6326, and 6350. That is, switch controller 625 is configured to switch ON/OFF switches 6226, 6326, and 6350 in accordance with the operation of system 600.

During operation, when system 600 is working properly switch 6226 is ON and switches 6326 and 6350 are both OFF such that power source 605 provides power to electronic device 615. In the unlikely event that power source 605 and/or primary bus 622 malfunctions, switches 6326 and 6350 both turn ON, and switch 6226 turns OFF such that power source 610 provides power to electronic device 615. In this manner, system 600 ensures that power is supplied to electronic device 615 and that the high side of input circuit 620 is isolated. Furthermore, because input circuit 620 uses switches 6226 and 6326 for high side isolation, input circuit 620 consumes less power and is lighter in weight than previous input circuits.

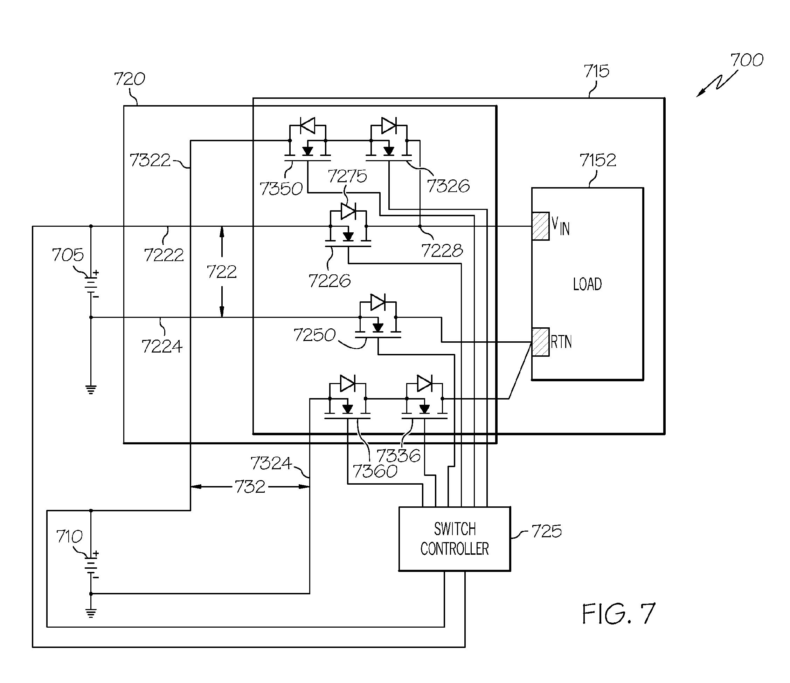

FIG. 7 is a schematic diagram of an electronic system 700 having a plurality of power sources 705, 710 coupled to an electronic device 715 via an input circuit 720 including a high/low side isolation, dual bus configuration. System 700 also includes a switch controller 725 coupled to input circuit 720 and configured to control the ON/OFF state of one or more switches (discussed below) included in input circuit 720.

In the embodiment illustrated in FIG. 7, power sources 705, 710 and electronic device 715 (including load 7152) are similar to power sources 205, 210 and electronic device 215 (and load 2152), respectively, discussed above with reference to FIG. 2. Among other elements, one difference between system 200 and system 700 is that input circuit 220 uses diodes 2226, 2250, 2326, and 2336 for high/low side isolation and input circuit 720 uses switches 7226, 7250, 7326, 7336, 7350, and 7360 for high/low side isolation.

Input circuit 720 includes a primary bus 722 including a return line 7224 and an input line 7222 coupling power source 705 to load 7152. Return line 7224 connects the negative terminal of power source 705 to the RTN terminal of load 7152 and includes switch 7250. In the embodiment illustrated in FIG. 7, switch 7250 is an N-channel MOSFET device including a source coupled to the negative terminal of power source 705 and a drain coupled to the RTN terminal of load 7152.

Input line 7222 includes switch 7226 coupled to the positive terminal of power supply 705 and to a node 7228, which is connected to the Vᵢₙ terminal of load 7152. In the embodiment illustrated in FIG. 7, switch 7226 is an N-channel MOSFET device including a source coupled to the positive terminal of power supply 705 and a drain coupled to node 7228.

Input circuit 720 further includes a secondary (or redundant) bus 732 comprising a return line 7324 and an input line 7322 coupling power source 710 to load 7152. That is, return line 7324 connects the negative terminal of power source 710 to the RTN terminal of load 7152. Specifically, return line 7324 comprises switch 7336 coupled to the RTN terminal of load 7152. Switch 7336 is further coupled in series with switch 7360, which is coupled to the positive terminal of power supply 710.

In the embodiment illustrated in FIG. 7, switches 7360 and 7336 are serially coupled via the drain of switch 7360 and the source of switch 7336. The source of switch 7360 is coupled to the negative terminal of power source 710, and the drain of switch 7336 is coupled to the RTN terminal of load 7152.

Input line 7322 connects the positive terminal of power source 710 to node 7228, which is coupled to the Vᵢₙ terminal of load 7152. Specifically, input line 7322 comprises switch 7326 coupled to node 7228. Switch 7326 is further coupled in series with switch 7350, which is coupled to the positive terminal of power supply 710.

In the embodiment illustrated in FIG. 7, switches 7350 and 7326 are serially coupled via their respective sources. The drain of switch 7350 is coupled to the positive terminal of power source 710, and the drain of switch 7326 is coupled to node 7228.

Switch controller 725 may be any system, device, hardware (and software), and combinations thereof capable of controlling the ON/OFF state of switches 7226, 7250, 7326, 7336, 7350, and 7360. That is, switch controller 725 is configured to switch ON/OFF switches 7226, 7250, 7326, 7336, 7350, and 7360 in accordance with the operation of system 700.

During operation, when system 700 is working properly switches 7226 and 7250 are both ON, and switches 7326, 7350, 7336, and 7360 are each OFF such that power source 705 provides power to electronic device 715. In the unlikely event that power source 705 and/or primary bus 722 malfunctions, switches 7326, 7350, 7336, and 7360 each turn ON, and switches 7226 and 7250 are both turned OFF such that power source 710 provides power to electronic device 715. In this manner, system 700 ensures that power is supplied to electronic device 715 and that the high side and low side of input circuit 720 are isolated. Furthermore, because input circuit 720 uses switches 7226, 7250, 7326, 7336, 7350, and 7360 for high/low side isolation, input circuit 720 consumes less power and is lighter in weight than previous input circuits.

While at least one exemplary embodiment has been presented in the foregoing detailed description of the invention, it should be appreciated that a vast number of variations exist. It should also be appreciated that the exemplary embodiment or exemplary embodiments are only examples, and are not intended to limit the scope, applicability, or configuration of the invention in any way. Rather, the foregoing detailed description will provide those skilled in the art with a convenient road map for implementing an exemplary embodiment of the invention, it being understood that various changes may be made in the function and arrangement of elements described in an exemplary embodiment without departing from the scope of the invention as set forth in the appended claims and their legal equivalents.

## Claims

1. An input circuit for an electronic device configured to be coupled to a plurality of power sources, comprising:
a first bus configured to be coupled to a first power source, the first bus including a first input line and a first return line, one of the first input line and the first return line comprising a first switch; and
a second bus configured to be coupled to a second power source, the second bus including a second input line and a second return line, one of the second input line and the second return line comprising a second switch and a third switch coupled in series.

2. The input circuit of claim 1, wherein the first switch, the second switch, and the third switch are each a metal oxide semiconductor field-effect transistor (MOSFET) device.

3. The input circuit of claim 1, wherein:
the first input line comprises the first switch;
the second input line comprises the second switch and the third switch coupled in series;
the first return line comprises a fourth switch; and
the second return line comprises a fifth switch and a sixth switch coupled in series.

4. The input circuit of claim 3, wherein the first switch, the second switch, the third switch, the fourth switch, the fifth switch, and the sixth switch are each a metal oxide semiconductor field-effect transistor (MOSFET) device.

5. The input circuit of claim 3, wherein:
a first source of the second switch is coupled to a second source of the third switch; and
a drain of the fifth switch is coupled to a third source of the sixth switch.

6. An electronic system, comprising:
a first power source including a first positive terminal and a first negative terminal;
a second power source including a second positive terminal and a second negative terminal;
an electronic device including an input terminal and a return terminal; and
an input circuit coupling the electronic device to the first power source and the second power source, the input circuit comprising:
a first bus comprising:
a first input line coupling the input terminal and the first positive terminal,
a first switch coupled between the input terminal and the first positive terminal, and
a first return line coupling the return terminal and the first negative terminal, and
a second bus comprising:
a second input line coupling the input terminal and the second positive terminal,
a second switch and a third switch coupled in series between the input terminal and the second positive terminal, and
a second return line coupling the return terminal and the second negative terminal.

7. The electronic system of claim 6, wherein the first switch, the second switch, and the third switch are each a metal oxide semiconductor field-effect transistor (MOSFET) device.

8. The electronic system of claim 6, wherein:
the first return line comprises a fourth switch coupled between the return terminal and the first negative terminal; and
the second return line comprises a fifth switch and a sixth switch coupled in series between the return terminal and the second negative terminal.

9. The electronic system of claim 8, wherein the first switch, the second switch, the third switch, the fourth switch, the fifth switch, and the sixth switch are each a metal oxide semiconductor field-effect transistor (MOSFET) device.

10. The electronic system of claim 8, wherein:
a first source of the second switch is coupled to a second source of the third switch; and
a drain of the fifth switch is coupled to a third source of the sixth switch.
